(19) Europäisches Patentamt
European Patent Office
Office européen des brevets

(11) EP 0 795 756 A2

(12) EUROPÄISCHE PATENTANMELDUNG

(43) Veröffentlichungstag:
17.09.1997 Patentblatt 1997/38

(51) Int. Cl.$^6$: G01R 31/26

(21) Anmeldenummer: 97102147.2

(22) Anmeldetag: 11.02.1997

(84) Benannte Vertragsstaaten:
DE FR GB IT

(30) Priorität: 14.03.1996 DE 19610065

(71) Anmelder: SIEMENS AKTIENGESELLSCHAFT
80333 München (DE)

(72) Erfinder: Farokzhad, Babak
70771 Leinfelden-Echterdingen (DE)

(54) **Verfahren zur Abschätzung der Lebensdauer eines Leistungshalbleiter-Bauelements**

(57) Nach den Vorschlägen einer Gruppe von Forschungsinstituten, Herstellern und Anwendern soll ein IGBT-Leistungshalbleitermodul dann als defekt oder fehlerhaft eingestuft werden, wenn die während eines schnellen Lastwechseltests gemessene Kollektor-Emitter-Spannung $U_{CE}$ um mehr als einen vorgegebenen Prozentsatz von ihrem Anfangswert abweicht. Da die entsprechende Degradation der Spannung $U_{CE}$ bei langlebigen Modulen oft erst nach mehreren $10^5$ Zyklen auftritt, nimmt der Lastwechseltest mehrere Wochen oder gar Monate in Anspruch.

Das neue Verfahren nutzt die Erkenntnis, daß der Anstieg der Kollektor-Emitter-Spannung $U_{CE}$ während des Lastwechseltests korreliert ist mit der erwarteten Lebensdauer des betreffenden IGBT-Moduls. So kann man einem Testmodul schon nach einem Bruchteil der bisher benötigten Meßzeit die Eigenschaft "langlebiger als ein Referenzmodul" bzw. "ausfallresistenter" zuordnen, sofern die Ableitungen der jeweiligen Spannung $U_{CE}$ nach der Anzahl N der Lastwechsel der Bedingung $(dU_{CE}/dN)_{Test} < (dU_{CE}/dN)_{Ref}$ genügen.

Test von IGBT-Modulen; Bewertung von Technologien; Qualitätssicherung; Qualitätskontrolle;

FIG 6

Ucesat

Lastwechselzahl N

Uce 1
Uce 2
Polynomisch (Uce 1)
Polynomisch (Uce 2)

EP 0 795 756 A2

**Beschreibung**

**1. Einleitung und Stand der Technik**

Aufgrund ihrer exzellenten elektrischen Eigenschaften und der vergleichsweise einfach aufgebauten Ansteuerelektronik kommen IGBT (Isolated Gate Bipolar Transistor) Leistungshalbleitermodule zunehmend auch in ausfallkritischen Systemen zum Einsatz. Da insbesondere die für die Traktionskontrolle von schienengebundenen Fahrzeugen (Lokomotiven, S- und U-Bahnen, Straßenbahnen usw.) vorgesehenen Einheiten während der oft jahrzehntelangen Betriebsdauer häufig großen mechanischen und thermischen Belastungen unterworfen sind, stellen die Anwender höchste Ansprüche an die Zuverlässigkeit und Lebensdauer der eingesetzten IGBT-Module.

Zur Zeit existiert noch kein standardisiertes Verfahren zum Testen der Zuverlässigkeit von IGBT-Leistungshalbleitermodulen. Eine Gruppe von Forschungsinstituten, Herstellern und Anwendern hat sich mit dieser Problematik befaßt und in [1] eine entsprechende Testmethode zur Diskussion gestellt. Gemäß den Vorschlägen dieser Gruppe soll das IGBT-Modul unter definierten Bedingungen einer Vielzahl von Lastwechseln unterworfen und insbesondere dann als defekt oder fehlerhaft eingestuft werden, wenn die nach jeweils mehreren tausend Zyklen gemessene Kollektor-Emitter-Spannung ($U_{CEsat}$) um mehr als einen vorgegebenen Prozentsatz (20% dividiert durch die Anzahl der Chips im Modul) vom Anfangswert abweicht. Selbst wenn man diese Bedingung entschärft und eine 10%ige Unterschreitung der Anfangsspannung noch toleriert, tritt die entsprechende Degradation bei langlebigen Modulen erst nach einigen hunderttausend Lastwechseln auf. Da die Zyklusdauer ($t_{ein} + t_{aus}$) typischerweise im Bereich von etwa 10 bis 20 Sekunden liegt, nimmt der Zuverlässigkeits-/Lebensdauertest somit eine für die Routinekontrolle in der Produktion viel zu lange Meßzeit von mehreren Wochen oder gar Monaten in Anspruch.

Das in [2] beschriebene Verfahren zur Prüfung der Zuverlässigkeit elektronischer Bauelemente beruht auf der Annahme, daß eine Steigerung der Belastung eines Testobjektes eine Beschleunigung des Ausfallmechanismus zur Folge hat. Solange der Ausfallmechanismus erhalten bleibt, läßt sich die Testzeit dann entsprechend einer sogenannten Zeitraffungskurve verkürzen. Die einzelnen Punkte der Zeitraffungskurve erhält man beispielsweise aus einer Vielzahl jeweils an Stichproben von Testobjekten gemessener Ausfallverteilungskurven unter Verwendung eines die erwartete Verteilung der Lebensdauer näherungsweise beschreibenden mathematischen Modells.

**2. Gegenstand und Vorteile der Erfindung**

Das im folgenden beschriebene Testverfahren ermöglicht es, die Lebensdauer eines Leistungshalblei-terbauelements schon frühzeitig abzuschätzen bzw. dem Bauelement nach vergleichsweise wenigen Lastwechseln die Eigenschaft "langlebiger als ein Referenzelement" oder "kurzlebiger als ein Referenzelement" zuzuordnen.

Das in Patentanspruch 1 angegebene Verfahren findet insbesondere im Bereich der Entwicklung und Fertigung von IGBT-Leistungshalbleitermodulen Verwendung. Es erlaubt schon nach verhältnismäßig kurzer Zeit festzustellen, welche der untersuchten Technologien die größten Vorteile hinsichtlich der Zuverlässigkeit/Haltbarkeit der Module bietet und welche Prozeßparameter ggf. noch einer Optimierung bedürfen. In der Qualitätskontrolle eingesetzt, kann man die der laufenden Produktion entnommenen Stichproben schneller als bisher überprüfen und die entsprechende Charge zur Auslieferung an die Kunden freigeben.

**3. Zeichnungen**

Die Erfindung wird im folgenden anhand der Zeichnungen erläutert. Es zeigen:

Figur 1      die Abhängigkeit des Hilfsemitterwiderstandes ($R_H$) verschiedener IGBT-Bauelemente eines Moduls von der Anzahl (N) der Lastwechsel;

Figur 2      die Steigung ($dR_H/dN$) der Hilfsemitterwiderstände in Abhängigkeit von der Anzahl (N) der Lastwechsel;

Figur 3      die Beschaltung eines IGBT-Bauelements während der Messung des Hilfsemitterwiderstandes ($R_H$);

Figur 4      die Beschaltung eines IGBT-Bauelements während der Messung des Emitterwiderstandes ($R_E$);

Figur 5      die Beschaltung eines IGBT-Bauelements während der Messung des Widerstandes ($R_{EH}$) zwischen Emitter und Hilfsemitter;

Figur 6 und Figur 7      die Kollektor-Emitter-Spannungen ($U_{CEsat}$) zweier IGBT-Leistungshalbleitermodule in Abhängigkeit von der Anzahl (N) der Lastwechsel sowie die jeweils berechneten Ausgleichspolynome.

**4. Beschreibung der Ausführungsbeispiele**

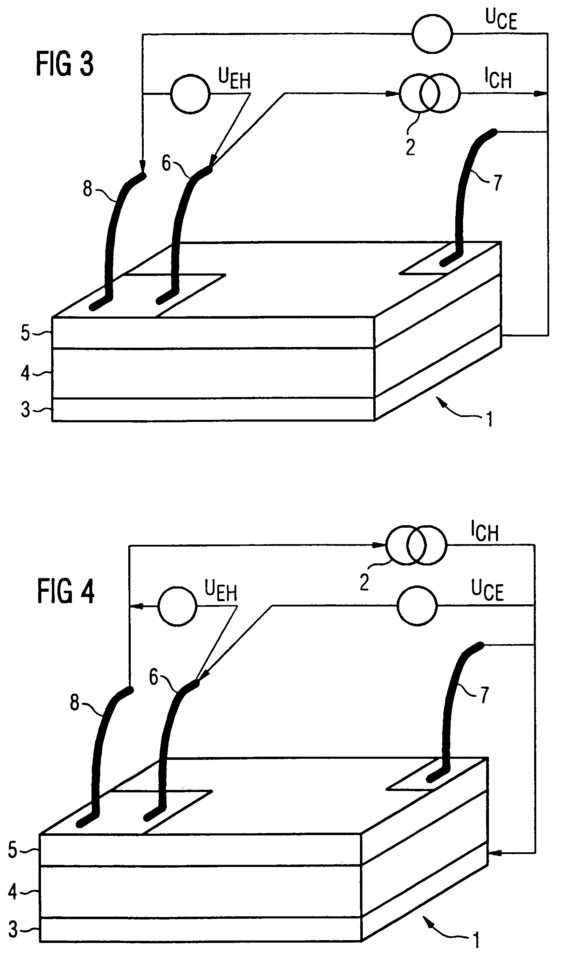

Da die üblicherweise aus Aluminium bestehenden elektrischen Anschlüsse eines IGBT-Bauelements und der zu kontaktierende Siliziumchip unterschiedlich große thermische Ausdehnungskoeffizienten besitzen, treten im Bereich der Bonddrähte während des Betriebes mechanische Scherkräfte auf. Als Folge dieser Scherkräfte bilden sich im Metall feine Haarrisse, welche ständig wachsen und den Bonddraht allmählich von seiner Unterlage lösen. Der betreffende Bonddraht hebt schließlich von der Metallisierung ab und unterbricht dadurch die Strom-/Spannungsversorgung des IGBT-Bauelements (s. die Fig. 3-6 in [1]). Dieser Mechanismus fuhrt am häufigsten zum Ausfall der aus mehreren Bauelementen bestehenden IGBT-Module, wobei die während des Betriebes nicht strombelasteten Hilfsemitter zumindest bei kleinen Strömen meist noch vor den jeweiligen Hauptemittern abheben.

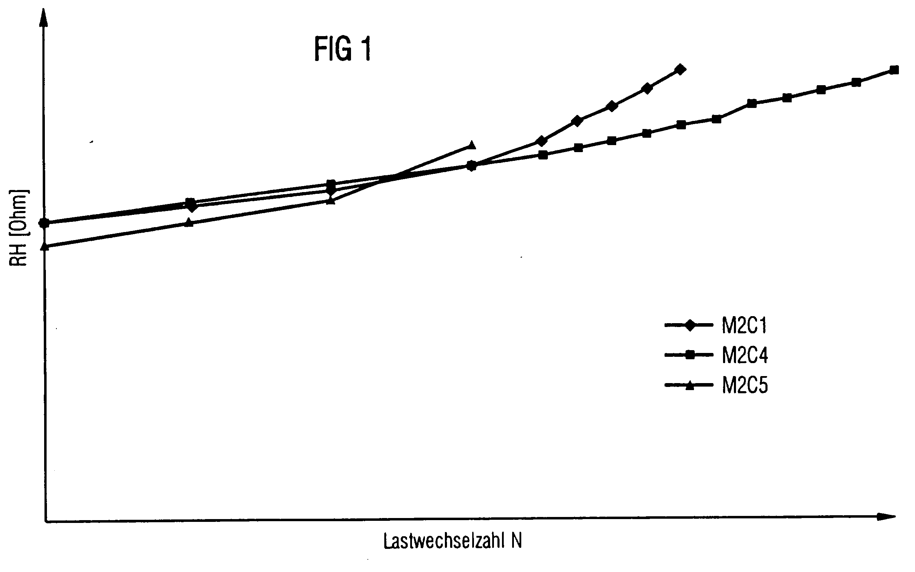

Die Degradation der Bonddrähte hat eine Änderung des Bonddrahtwiderstandes zur Folge, so daß dieser als Indikator für die Zuverlässigkeit/Haltbarkeit des jeweiligen Anschlusses und damit der Lebensdauer des Bauelements bzw.des betreffenden IGBT-Moduls dienen kann. Im Rahmen entsprechender Untersuchungen hat sich gezeigt, daß ein Bauelement des Moduls um so früher durch das Abheben eines Bonddrahtes ausfällt, je schneller der Bonddrahtwiderstand mit der Zeit bzw. mit der Anzahl N der durchgeführten Lastwechsel zunimmt. Figur 1 zeigt die Ergebnisse der an drei der insgesamt sechs Bauelemente (10 A, 600 V) eines IGBT-Moduls durchgeführten Messungen. Dargestellt ist der Widerstand $R_H$ des jeweiligen Hilfsemitters in Abhängigkeit von der Anzahl N der Lastwechsel. Die Testparameter sind in Tabelle I angegeben.

Tabelle I

| (Testparameter) | |
|---|---|
| Ein-/Auszeit pro Zyklus | $t_{ein} = 10$ s; $t_{aus} = 20$ s |
| Temperaturspreizung | $\Delta T = 100$ K |
| Anzahl der Zyklen | $N \approx 10^4$ |
| Gatespannung | $U_G = 15$ Volt |
| Kollektorstrom | $I_C = 3$ A |

Den stärksten Anstieg zeigt der an Bauelement M2C5 gemessene Widerstand $R_H$ des Hilfsemitters. Dieses Bauelement fiel auch bereits nach etwa der Hälfte der geplanten Anzahl von Lastwechseln durch Abheben des Emitterbonddrahtes aus. Etwas langlebiger ist das Bauelement M2C1. Der Widerstand seines Hilfsemitters besitzt anfangs annähernd dieselbe Zeitabhängigkeit wie der Hilfsemitterwiderstand des im durchgeführten Lastwechseltest langlebigsten Bauelements M2C4. Der Ausfall des Bauelements M2C1 kündigt sich nach etwa der Hälfte der Meßzeit durch einen stärkeren Anstieg des Hilfsemittrewiderstandes frühzeitig an. Ausfallkritische Werte erreicht der an Bauelement M2C4 gemessene Widerstand des Hilfsemitters erst sehr viel später.

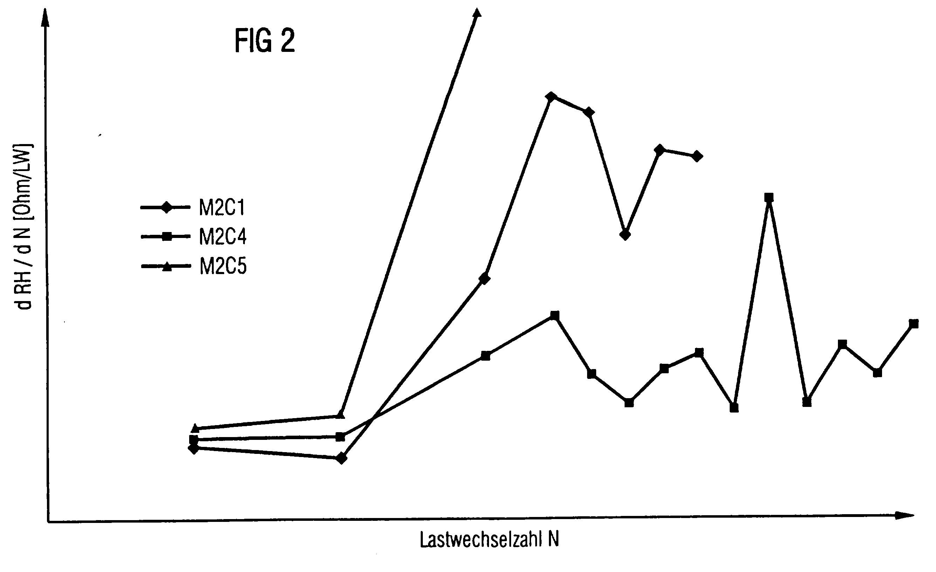

Die Korrelation zwischen dem Verlauf des Hilfsemitterwiderstandes $R_H$ und der erwarteten Lebensdauer des jeweiligen IGBT-Bauelements läßt sich auch anhand der Figur 2 nachweisen. Dargestellt ist der Anstieg $dR_H/dN$ des jeweiligen Hilfsemitterwiderstandes $R_H$ in Abhängigkeit von der Anzahl N der Lastwechsel. Man erkennt deutlich, daß ein IGBT-Bauele-ment um so früher ausfällt, je stärker der Widerstand $R_H$ seines Hilfsemitters mit der Zeit ansteigt. Durch Vergleich der an einem Testelement gemessenen Ableitung $dR_H/dN$ mit dem entsprechenden Wert $(dR_H/dN)_{Ref}$ eines Referenzelementes kann man dem Testelement somit schon nach vergleichsweise wenigen Lastwechseln die Eigenschaft "kurzlebiger als das Referenzelement" $(dR_H/dN > (dR_H/dN)_{Ref})$ oder "langlebiger als das Referenzelement" $(dR_H/dN < (dR_H/dN)_{Ref})$ zuordnen. Sind das Testelement und das Referenzelement jeweils die ausfallfreudigsten Komponenten ihrer Einheit, so ist auch das betreffende Testmodul kurzlebiger/langlebiger als das Referenzmodul.

Zur Messung des Widerstandes $R_H$ wird der Lastwechseltest kurz unterbrochen und das IGBT-Bauelement 1 mit einer regelbaren Konstantstromquelle 2 derart verbunden, daß der in den Kollektor 3 jeweils eingespeiste Strom $I_{CH}$ über den Halbleiterchip 4 und die obere Metallisierung 5 zum Hilfsemitter 6 und von dort zur Quelle 2 fließt (s. Figur 3). Der durch einen Isolator vom Halbleiterchip 4 getrennte Gateanschluß 7 bleibt ebenso wie der Emitteranschluß 8 stromlos. Nach Aufzeichnung der zwischen Emitter 8 und Hilfsemitter 6 abfallenden Spannung $U_{EH}$ ändert man die Stromstärke $I_{CH}$, um zumindest eine weitere Messung der Potentialdifferenz $U_{EH}$ vorzunehmen. Die beispielsweise durch eine lineare Regression gewonnene Steigung der $U_{EH}/I_{CH}$-Kennlinie liefert dann den gesuchten Widerstand $R_H$.

Wie oben erläutert, unterliegt auch der als Emitteranschluß dienende Bonddraht 8 einer Degradation. Die durch starke Scherkräfte hervorgerufenen Haarrisse beeinflussen wieder den Kontaktwiderstand, so daß sich durch Messung des Emitterwiderstandes $R_E$ oder des Widerstandes $R_{EH}$ zwischen Emitter 8 und Hilfsemitter 6 die Bonddrahtqualität beurteilen und die Lebensdauer des betreffenden Bauelements bzw. IGBT-Moduls abschätzen läßt. So besitzt ein Bauelement 1 eine längere Lebenserwartung als ein Bauelement 2, wenn die Ableitungen der Bedingung

$$(dR_E/dN)_1 < (dR_E/dN)_2$$

bzw

$$(dR_{EH}/dN)_1 < (dR_{EH}/dN)_2$$

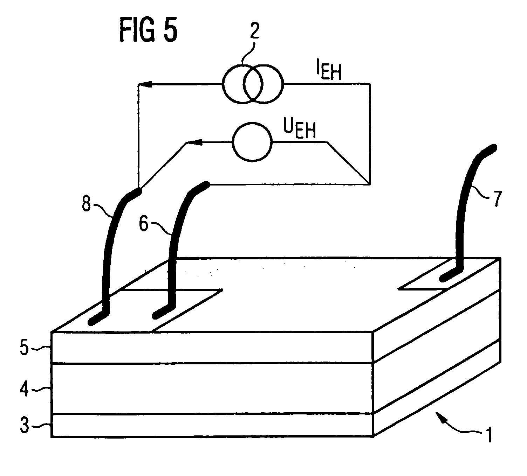

genügen. Die entsprechenden Meßaufbauten sind in Figur 4 ($R_E$-Messung) und Figur 5 ($R_{EH}$-Messung) schematisch dargestellt.

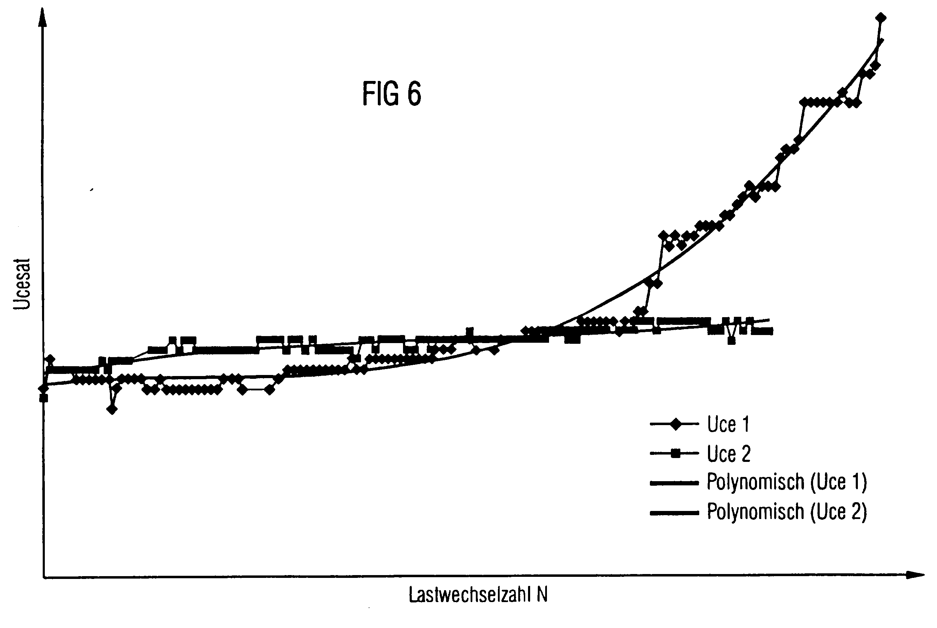

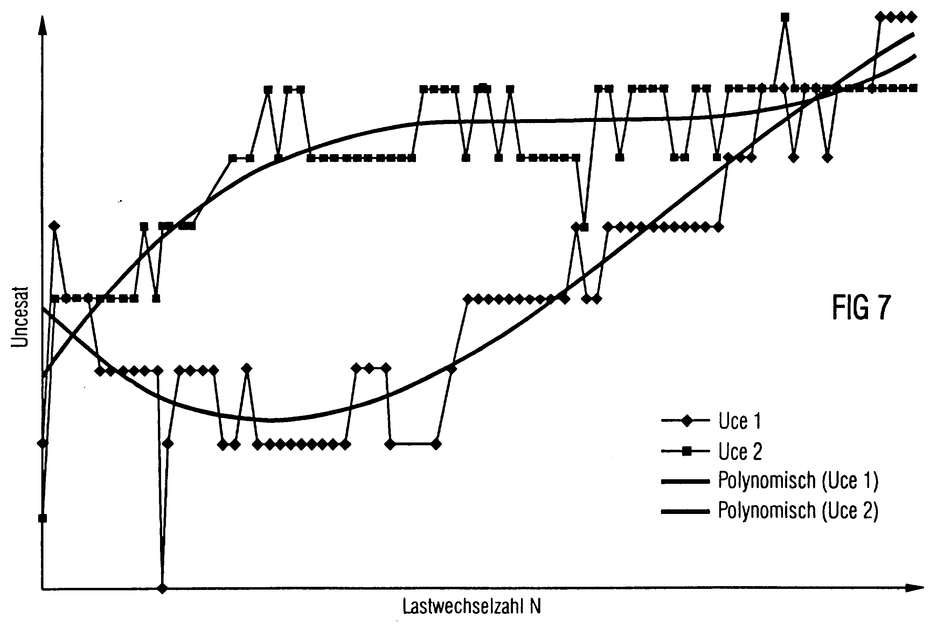

Größere IGBT-Leistungshalbleitermodule besitzen üblicherweise keine unmittelbar an den Halbleiterchips angebondete Hilfsemitter. Um die erwartete Lebensdauer dieser Module abzuschätzen, untersucht man vorteilhafterweise die Degradation der Kollektor-Emitter-Sättigungsspannung $U_{CEsat}$ während eines Lastwechseltests und insbesondere die Steigung $dU_{CEsat}/dN$. Figur 6 zeigt die an zwei IGBT-Modulen (300 A, 1600 V) jeweils gemessenen Sättigungsspannungen $U_{CEsat}$ in Abhängigkeit von der Anzahl N der Lastwechsel und die zugeordneten Ausgleichspolynome dritten Grades (durchgezogene Kurven). Die beiden Module unterscheiden sich im wesentlichen nur dadurch, daß während ihrer Herstellung jeweils andere Technologien zur Anwendung kamen. Der Lastwechseltest wurde abgebrochen, als die Sättigungsspannung $U_{CEsat}$ des Moduls Nr. 1 um 10% von ihrem Anfangswert abwich. Anhand des Anstiegs $dU_{CEsat}/dN$ der Sättigungsspannung $U_{CEsat}$ bzw. der Steigung des zugeordneten Ausgleichspolynoms kann man spätestens nach etwa 2/3 der Testzeit mit großer Wahrscheinlichkeit vorhersagen, daß Modul 1 früher als Modul 2 das Ausfallkriterium (10%ige Abweichung der $U_{CEsat}$-Spannung von ihrem Anfangswert) erfüllen wird. Der für die Prognose der erwarteten Lebensdauer relevante Zeitbereich ist in Figur 7 dargestellt. Bei der Berechnung der Ausgleichspolynome wurden, im Unterschied zu Figur 6, nur die bereits nach etwa der Hälfte der Meßzeit vorliegenden Daten berücksichtigt. Deutlich zu erkennen ist die nach einer Anlaufphase größere Steigung des Modul Nr. 1 zugeordneten Ausgleichspolynoms. Da auch die zweiten Ableitungen der Bedingung

$$(d^2U_{CEsat}/dN^2)_1 > (d^2U_{CEsat}/dN^2)_2$$

genügen, kann man Modul 1 schon nach etwa der Hälfte der geplanten Lastwechsel mit großer Sicherheit die Eigenschaft "kurzlebiger als Modul 2" zuordnen.

Wird die erwartete Lebensdauer eines Moduls durch Analyse des $U_{CEsat}$-Verlaufs bereits nach vergleichsweise wenigen Lastwechseln vorgenommen, führt dies notwendigerweise zu einer erhöhten Unsicherheit der Prognose. Neben der ersten und der zweiten Ableitung der Sättigungsspannung $U_{CEsat}$ sollten die aufgezeichneten Degradationskurven deshalb ggf. noch einer Zeitreihen-, Trend- oder Spektralanalyse unterzogen werden. Entsprechende Verfahren sind aus dem Bereich der Statistik bekannt.

## 5. Ausgestaltungen und Weiterbildungen

Das oben beschriebene Verfahren kommt insbesondere in den Bereichen Forschung, Entwicklung und Qualitätssicherung zum Einsatz. Die Möglichkeit, IGBT-Bauelemente und IGBT-Module durch Analyse der aufgezeichneten Degradationskurven ($R_H$-, $R_E$-, $R_{EH}$- und $U_{CEsat}$-Kurven) nach ihrer erwarteten Lebensdauer zu klassifizieren, läßt sich aber auch in Traktionssystemen vorteilhaft nutzen. Die ohnehin rechnergesteuerte Kontrolleinheit kann beispielsweise die $U_{CEsat}$-Spannungen der einzelnen Bauelemente periodisch abfragen, die aufgezeichneten Kurven analysieren und ein Warnsignal erzeugen, wenn eine der Spannungen $U_{CEsat}$ bzw. deren Steigung $dU_{CEsat}/dN$ einen den bevorstehenden Ausfall signalisierenden kritischen Wert erreicht.

## 6. Literatur

[1] Proceedings of the 20th International Symposium for Testing and Failure Analysis, Los Angeles, 13.- 18. Nov. 1994, S. 319 - 325
[2] Koschel, H., Jäger, A.: Zeitraffende Zuverlässigkeitsprüfungen an Transistoren; Sonderdruck aus Nachrichtentechnische Zeitschrift, Heft 5 (1964)

## Patentansprüche

1. Verfahren zur Abschätzung der Lebensdauer eines Leistungshalbleiter-Bauelements, bei dem

   - das Bauelement einem periodischen Lastwechsel unterworfen wird,
   - ein als Indikator für die Zuverlässigkeit oder Haltbarkeit dienender elektrischer Parameter P des Bauelements in Abhängigkeit von der Anzahl N der Lastwechsel gemessen wird,
   - die Ableitung dP/dN des elektrischen Parameters P nach der Anzahl N der Lastwechsel bestimmt wird und bei dem
   - die Ableitung dP/dN mit einem eine bestimmte Lebensdauer repräsentierenden Sollwert verglichen wird.

2. Verfahren nach Anspruch 1,
   **dadurch gekennzeichnet,**
   daß die Ableitung dP/dN mit den an einem Referenzelement unter den gleichen Bedingungen innerhalb desselben Intervalls von Lastwechseln gemessenen Ableitung $(dP/dN)_{Ref}$ verglichen wird.

3. Verfahren nach Anspruch 2,
   **dadurch gekennzeichnet,**
   daß das Bauelement gegenüber dem Referenzelement als langlebiger eingestuft wird, sofern die Bedingung

   $$dP/dN < (dP/dN)_{Ref}$$

   innerhalb des betrachteten Intervalls von Lastwechseln erfüllt ist und daß das Bauelement gegenüber dem Referenzelement als kurzlebiger eingestuft wird, sofern die Bedingung

   $$dP/dN > (dP/dN)_{Ref}$$

   innerhalb des betrachteten Intervalls von Lastwechseln erfüllt ist.

4. Verfahren nach Anspruch 2,

**dadurch gekennzeichnet ,**
daß zumindest die zweite Ableitung $d^2P/dN^2$ berechnet und mit der entsprechenden Ableitung $(d^2P/dN^2)_{Ref}$ des Referenzelements verglichen wird.

5. Verfahren nach Anspruch 2,
   **dadurch gekennzeichnet,**
   daß ein Warnsignal erzeugt wird, falls die Ableitung $dP/dN$ größer ist als der Sollwert.

6. Verfahren nach einem der Ansprüche 1 bis 5,
   **dadurch gekennzeichnet,**
   daß die Potentialdifferenz zwischen zwei Anschlüssen des Bauelements, der ohmsche Widerstand zwischen zwei Anschlüssen oder der ohmsche Widerstand eines Bauelementanschlusses als Parameter P dienen.

7. Verfahren nach Anspruch 6,
   **dadurch gekennzeichnet,**
   daß der Lastwechsel an einem einen Emitteranschluß (8), einen Hilfsemitteranschluß (6) und einen Kollektoranschluß (3) aufweisenden Leistungshalbleiter-Bauelement (1) durchgeführt wird und daß der Widerstand ($R_{EH}$) zwischen dem Emitter- und Hilfs-emitteranschluß (8, 6), der Widerstand ($R_E$, $R_H$) des Emitters (8) oder des Hilfsemitters (6) oder die Kollektor-Emitter-Spannung ($U_{CESat}$) in Abhängigkeit von der Anzahl N der Lastwechsel gemessen wird.

FIG 1

RH [Ohm]

Lastwechselzahl N

M2C1
M2C4
M2C5

EP 0 795 756 A2

FIG 2

FIG 3

$U_{CE}$

$U_{EH}$

$I_{CH}$

8

6

2

7

5

4

3

1

FIG 4

$I_{CH}$

$U_{EH}$

$U_{CE}$

2

6

8

7

5

4

3

1

**FIG 5**

FIG 6

EP 0 795 756 A2

FIG 7

Uncesat

Lastwechselzahl N

◆ Uce 1
■ Uce 2
—— Polynomisch (Uce 1)
—— Polynomisch (Uce 2)

EP 0 795 756 A2